# EUROPÄISCHE PATENTSCHRIFT

(11) **EP 1 052 595 B1**
(45) Veröffentlichungstag und Bekanntmachung des Hinweises auf die Patenterteilung: **19.09.2001**
(21) Anmeldenummer: 99811181.9
(22) Anmeldetag: 21.12.1999
(51) Int. Cl.: G06K 19/077

(54) **Transponder und Spritzgussteil sowie Verfahren zu ihrer Herstellung**
Transponder and injection-moulded object and method for manufacturing the same
Transpondeur et objet moulé par injection et procédé pour leur fabrication

(30) Priorität: 14.05.1999 EP 99810432
(43) Veröffentlichungstag der Anmeldung: 15.11.2000
(73) Patentinhaber: SOKYMAT S.A., 1614 Granges (Veveyse) (CH)
(72) Erfinder: Miehling, Martin, 1614 Granges, Vevey (CH)
(74) Vertreter: Wagner, Wolfgang, Dr. Phil., Dipl.-Phys.

(56) Entgegenhaltungen:
- EP-A- 0 692 770
- WO-A-98/53424
- US-A- 5 690 773
- US-A- 5 800 763

## Beschreibung

### Technisches Gebiet

Die Erfindung betrifft einen Transponder, wie sie vor allem in Karten oder Marken zur Identifikation von Gegenständen verschiedener Art, aber auch von Personen oder Tieren eingesetzt werden. Ausserdem betrifft sie ein Spritzgussteil mit einem integrierten Transponder sowie Verfahren zur Herstellung des Transponders und des Spritzgussteils.

### Stand der Technik

Aus der EP-A-0 692 770 ist ein gattungsgemässer Transponder bekannt, welcher die Form einer Kreditkarte hat. Er weist einen Schaltkreis auf, der aus einer Spule und einer mit derselben elektrisch leitend verbundenen integrierten Schaltung besteht, welche vollständig von Spritzgussmasse - PVC, ABS, PET PC oder Polyamid - umgeben sind. Zur Herstellung des Transponders sind zwei Spritzgussschritte erforderlich, bei denen Spritzgussmasse mit einem Druck von über 600 bar und zwangsläufig verhältnismässig hohen Temperaturen eingespritzt wird. Dies kann leicht zur Beschädigung der Spule und der integrierten Schaltung und damit zu einem hohen Anteil an Ausschuss führen, zumal beim ersten Spritzgussschritt, bei dem der Schaltkreis in die Form lediglich eingelegt ist, die Gefahr besteht, dass seine Teile verschoben werden.

Aus der US-A-5 420 757 ist ein weiterer Transponder bekannt, bei welchem der elektrische Schaltkreis in Epoxidharz oder thermoplastischem Material gekapselt ist. Die Kapselung wird ebenfalls im konventionellen Spritzgussverfahren hergestellt. Das Verfahren hat insofern die oben genannten Nachteile. Die Bauteile werden gegen Verschieben durch die unter hohem Druck eingespritzte Spritzgussmasse an aufwendigen Halterungen oder Trägern aus geeignetem Material fixiert. Die Halterungen durchdringen jedoch die Kapselung und müssen zudem durch Stanzen oder einen ähnlichen weiteren Arbeitsschritt durchtrennt werden. Die Herstellung einer lückenlosen Kapselung ist erschwert und verteuert.

Aus US-A-5 690 773 ist ein Transponder, wiederum in der Form einer Kreditkarte, bekannt, bei welchem ein Schaltkreis in einen Kunststoffrahmen eingelegt und dann mit Harz vergossen wird. Dieses Herstellungsverfahren ist jedoch verhältnismässig aufwendig.

### Darstellung der Erfindung

Der Erfindung liegt die Aufgabe zu Grunde, einen gattungsgemässen Transponder anzugeben, bei welchem die Bauteile des Schaltkreises in ihrer gegenseitigen Lage zuverlässig festgehalten sind und der auf einfache und kostengünstige Weise - insbesondere mit wenig Ausschuss - herstellbar ist. Vorzugsweise weist er eine den Schaltkreis vollständig umhüllende Kapselung auf. Ausserdem soll ein einfaches Verfahren zu seiner Herstellung angegeben werden. Diese Aufgabe wird durch die Merkmale im Kennzeichen des Anspruchs 1 bzw. des Anspruchs 12 gelöst.

Der Schaltkreis des erfindungsgemässen Transponders wird von einem Träger mindestens teilweise umhüllt, derart, dass er, insbesondere bei allfälligen weiteren Verarbeitungsschritten, gegen Beschädigungen geschützt ist. Der Träger kann auch als den Schaltkreis vollständig umhüllende Kapselung ausgebildet sein, so dass er gegen Beschädigung optimal geschützt ist und auch einer rauhen Umgebung ohne Bedenken ausgesetzt werden kann. Er kann leicht mit Folie, insbesondere Kunststoffolie laminiert werden.

Das Herstellungsverfahren ist einfach und setzt die Schaltkreise nur verhältnismässig tiefen Drücken und Temperaturen aus, so dass keine Gefahr einer Beschädigung derselben besteht und sie auch nicht aufwendig fixiert zu werden brauchen, sondern in der Regel lediglich eingelegt werden. Ausserdem können Aluminiumformen verwendet werden, welche wesentlich billiger sind als die beim.konventionellen Spritzgiessen eingesetzten Stahlformen. Die Formen müssen in der Regel nicht geheizt werden. Der geringe Druck erlaubt den Einsatz leichter und verhältnismässig billiger Spritzgussmaschinen.

Erfindungsgemässe Transponder können jedoch, da die Schaltkreise teilweise oder auch vollständig umhüllt und dadurch mindestens gegen eine Verschiebung ihrer Bauteile gesichert sind, den hohen Drücken und Temperaturen ausgesetzt werden, wie sie gewöhnlich beim Spritzgiessen auftreten. Die Erfindung umfasst daher auch Spritzgussteile, in die ein erfindungsgemässer Transponder, der in dafür besonders geeigneter Weise ausgebildet sein kann, integriert ist. Dabei kann es sich um Münzen, Gehäuse, Gebrauchsartikel, Paletten usw. handeln. Der Formgebung sind hier kaum Grenzen gesetzt. Die Herstellung solcher Spritzgussteile wird durch die Integration des erfindungsgemässen Transponders kaum erschwert, da er in die Kavität eingelegt und umspritzt werden kann, ohne dass er bei der Festlegung der Parameter besonders berücksichtigt zu werden bräuchte.

### Kurze Beschreibung der Zeichnungen

Im folgenden wird die Erfindung anhand von Figuren, welche lediglich ein Ausführungsbeispiel darstellen, näher erläutert. Es zeigen
- Fig. 1a: einen Querschnitt durch eine Form während einer ersten Phase einer ersten Ausführungsform des erfindungsgemässen Verfahrens zur Herstellung eines erfindungsgemässen Transponders,
- Fig. 1b: eine Draufsicht auf die untere Hälfte der Form gemäss Fig. 1a,
- Fig. 1c: einen Querschnitt durch die Form während einer zweiten Phase der ersten Ausführungsform des erfindungsgemässen Verfahrens zur Herstellung eines erfindungsgemässen Transponders,
- Fig. 1d: eine Draufsicht auf die untere Hälfte der Form gemäss Fig. 1c,
- Fig. 1e: einen Querschnitt durch einen erfindungsgemässen Transponder, hergestellt gemäss der ersten Ausführungsform des erfindungsgemässen Verfahrens,
- Fig. 1f: eine Draufsicht auf den erfindungsgemässen Transponder gemäss Fig. 1e,
- Fig. 2a: einen Querschnitt durch eine Form während einer ersten Phase einer zweiten Ausführungsform des erfindungsgemässen Verfahrens zur Herstellung eines erfindungsgemässen Transponders,
- Fig. 2b: einen Querschnitt durch die Form während einer zweiten Phase der zweiten Ausführungsform des erfindungsgemässen Verfahrens zur Herstellung eines erfindungsgemässen Transponders,
- Fig. 3a: einen Querschnitt durch eine Form während einer ersten Phase einer dritten Ausführungsform des erfindungsgemässen Verfahrens zur Herstellung eines erfindungsgemässen Transponders,
- Fig. 3b: einen Querschnitt durch die Form während einer zweiten Phase der dritten Ausführungsform des erfindungsgemässen Verfahrens zur Herstellung eines erfindungsgemässen Transponders,
- Fig. 4a: eine Draufsicht auf ein Zwischenprodukt einer vierten Ausführungsform des erfindungsgemässen Verfahrens zur Herstellung eines erfindungsgemässen Transponders,
- Fig. 4b: einen Querschnitt durch das Zwischenprodukt gemäss Fig. 4a,
- Fig. 4c: einen Querschnitt durch einen erfindungsgemässen Transponder, hergestellt gemäss der vierten Ausführungsform des erfindungsgemässen Verfahrens,
- Fig. 4d: eine Draufsicht auf den erfindungsgemässen Transponder gemäss Fig. 4c,
- Fig. 5a: einen Querschnitt durch eine Spritzgussform während einer Phase des erfindungsgemässen Verfahrens zur Herstellung eines erfindungsgemässen Spritzgusteils,
- Fig. 5b: einen Querschnitt durch ein erfindungsgemässes Spritzgussteil und
- Fig. 5c: eine Draufsicht auf das erfindungsgemässe Spritzgussteil gemäss Fig. 5b.

### Wege zur Ausführung der Erfindung

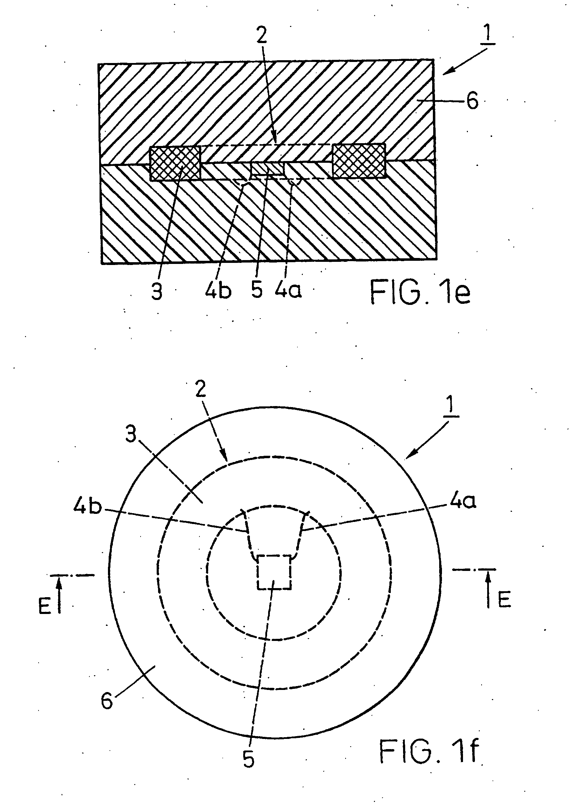

Ein erfindungsgemässer Transponder 1 (s. z. B. Fig. 1e,f) umfasst einen elektrischen Schaltkreis 2, der im Beispiel eine Spule 3 aus durch einen Backlack zusammengehaltenem Kupferdraht umfasst, mit Anschlüssen 4a,b, welche die Spule 3 mit einer ebenfalls zum Schaltkreis 2 gehörigen integrierten Schaltung 5 verbinden. Der Schaltkreis 2 ist in sich geschlossen und weist keine äusseren Anschlüsse auf. Mittels der Spule 3 kann er induktiv mit einem äusseren elektromagnetischen Wechselfeld wechselwirken und Energie aufnehmen sowie gespeicherte Daten aussenden und - bei geeigneter Ausbildung der integrierten Schaltung 5 - auch empfangen und speichern. Er ist vollständig von einer Kapselung 6 aus Schmelzkleber umschlossen.

Schmelzkleber zeichnen sich konventionellen Spritzgussgussmassen gegenüber vor allem durch eine niedrigere Schmelztemperatur und geringere Viskosität der Schmelze aus, obwohl sie ihnen in ihrer chemischen Zusammensetzung durchaus ähnlich sein können. Im Fall des oben beschriebenen Transponders etwa besteht der Schmelzkleber vorzugsweise aus Polyamid. Er weist eine Schmelztemperatur auf, die höchstens 250°C, vorzugsweise zwischen 180°C und 220°C beträgt. Die Viskosität der Schmelze ist gering.

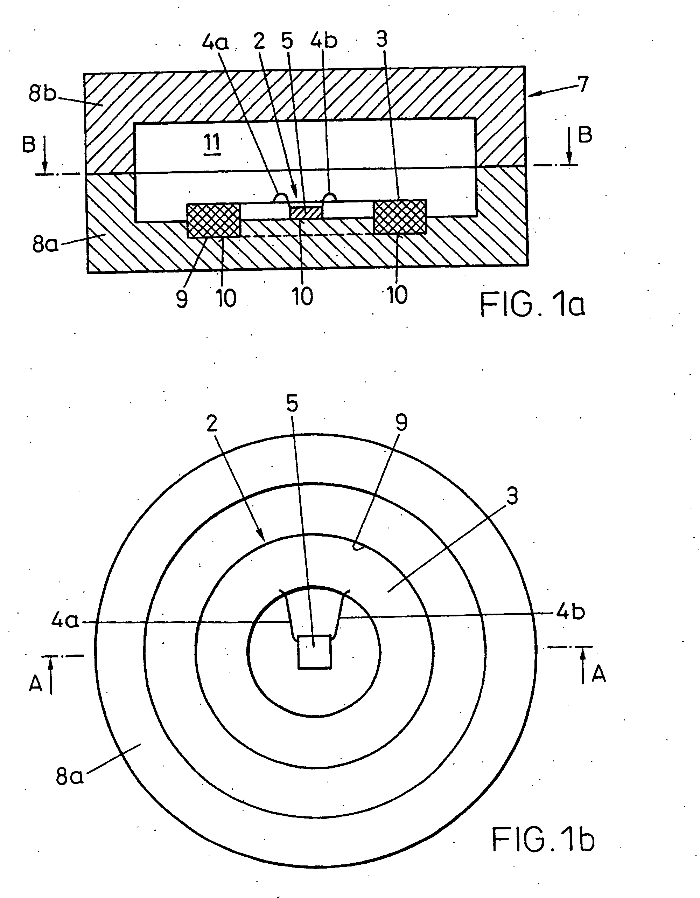

Gemäss einer ersten Ausführungsform des erfindungsgemässen Verfahrens zur Herstellung eines erfindungsgemässen Transponders wird (Fig. 1a,b) eine erste Form 7 bereitgestellt, die aus Aluminium bestehen kann. Sie umfasst eine untere Formhälfte 8a und eine obere Formhälfte 8b. Der Schaltkreis 2 wird in die untere Formhälfte 8a eingelegt, wobei die Spule 3 zur besseren Fixierung teilweise von einer Vertiefung 9 aufgenommen wird. Die integrierte Schaltung 5 liegt etwa im Zentrum der Spule 3 auf der unteren Formhälfte 8a auf und wird von den Anschlüssen 4a,b festgehalten. Der Schaltkreis 2 liegt somit mit einer Auflagefläche 10, die aus dem unteren Teil der Aussenfläche der Spule 3 und der Grundfläche der integrierten Schaltung 5 besteht, an einer entsprechenden Stützfläche der Form 7 an.

Nach dem Schliessen der ersten Form 7 durch Auflegen der zweiten Formhälfte 8b wird verflüssigter Schmelzkleber in die zwischen den Formhälften 8a,b gebildete Kavität 11 eingespritzt. Seine Temperatur liegt dabei etwas über der Schmelztemperatur, in der Regel bei ca. 200°C. Wegen der geringen Viskosität der Schmelze kann die Einspritzung mit niedrigem Druck von in der Regel ca. 20 bar erfolgen. Im allgemeinen liegen die Temperaturen je nach den Umständen zwischen 190°C und 230°C, höchstens bei 260°C, die Drücke zwischen 5 bar und 35 bis höchstens 40 bar. In der Kavität 11 liegen die Drücke meist tiefer, nämlich wenig über 0 bar, bis nach vollständiger Füllung auch dort der Einspritzdruck erreicht wird. Der in der Kavität 11 liegende Schaltkreis 2 wird teilweise, d. h. bis zur Mittelebene umhüllt, wobei die Auflagefläche 10 frei bleibt. Da dies ohne grosse thermische und mechanische Belastung geschieht, ist Beschädigung oder Verschiebung des Schaltkreises 2 durch die einströmende Schmelze nicht zu befürchten.

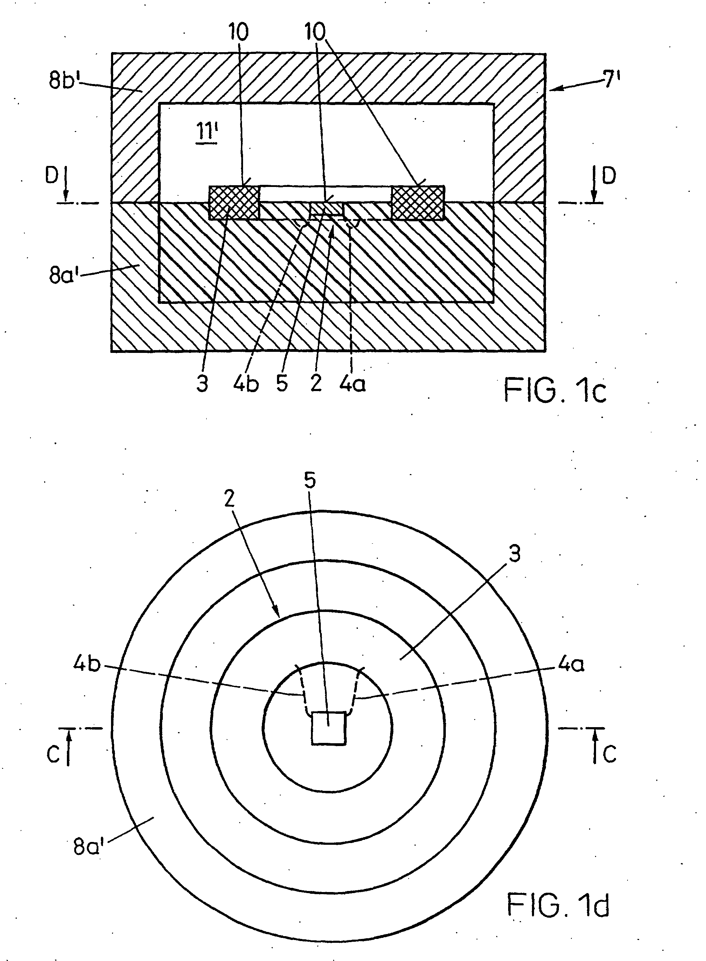

Nach dem Aushärten des Schmelzklebers wird der teilweise umhüllte Schaltkreis 2 aus der ersten Form 7 genommen, gewendet und in eine untere Formhälfte 8a' (Fig. 1c, d) einer höheren zweiten Form 7' eingelegt. Die Auflagefläche 10 weist dabei nach oben und liegt frei. Durch Auflegen einer oberen Formhälfte 8b' wird die Form 7' geschlossen und ihre Kavität 11' mit Schmelzkleber aufgefüllt. Nun ist auch die Auflagefläche 10 mit Schmelzkleber bedeckt und der Schaltkreis 2 lückenlos umhüllt. Die Kapselung 6 ist somit vollständig. Nach dem Aushärten des Schmelzklebers wird die Form 7' geöffnet und der scheibenförmige Transponder 1 (Fig. 1e,f) entnommen. Der ebenfalls ungefähr scheibenförmige Schaltkreis 2 ist symmetrisch in der Kapselung 6 angeordnet.

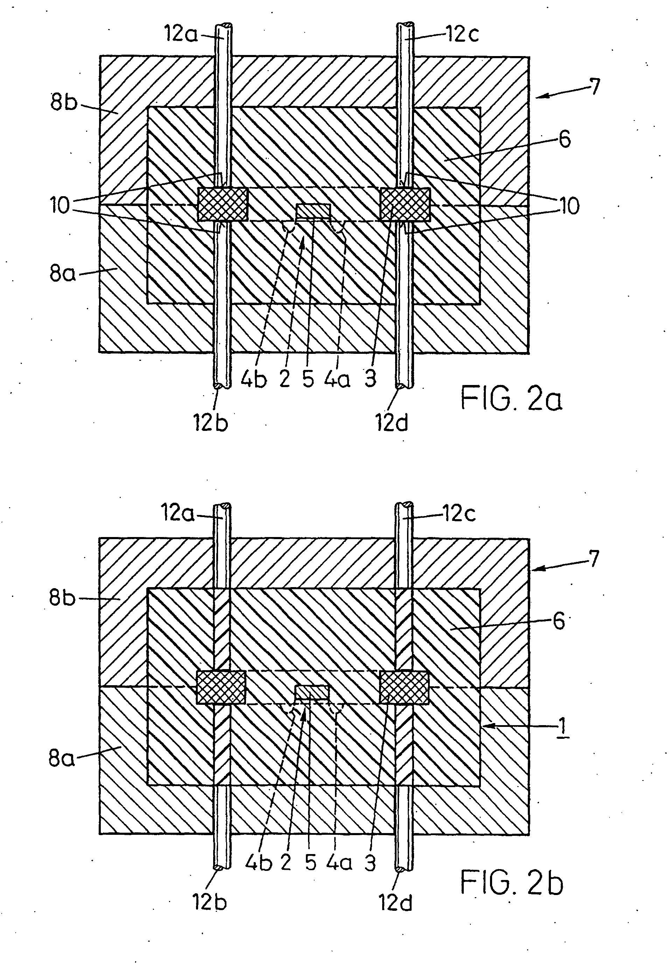

Gemäss einer zweiten Ausführungsform des erfindungsgemässen Verfahrens zur Herstellung eines erfindungsgemässen Transponders wird (Fig. 2a,b) nur eine Form 7 eingesetzt und. der Schaltkreis 2 mittels vier Stiften 12a,b,c,d in der Mitte der Kavität derselben festgehalten, deren Endflächen wiederum Stützflächen bilden, an welchen die Spule 3 mit einer aus vier Teilflächen bestehenden Auflagefläche 10 anliegt. Die Stifte 12a,b,c,d bilden zwei Paare 12a,b und 12c,d, welche jeweils gegeneinander gerichtet sind und die Spule 3 zwischen sich festklemmen.

Nach dem Einspritzen des Schmelzklebers und Aushärten desselben (Fig. 2a) werden die Stifte 12a,b,c,d jeweils bis zur Wand der Kavität zurückgezogen. Dann wird nachgespritzt und die durch den Rückzug der Stifte 12a,b,c,d entstandenen Hohlräume aufgefüllt (Fig. 2b). Damit ist die Kapselung 6 wiederum vollständig und der Schaltkreis 2 lückenlos von Schmelzkleber umhüllt. Nach dem Aushärten des nachgespritzten Schmelzklebers wird die Form 7 geöffnet und der Transponder 1 herausgenommen.

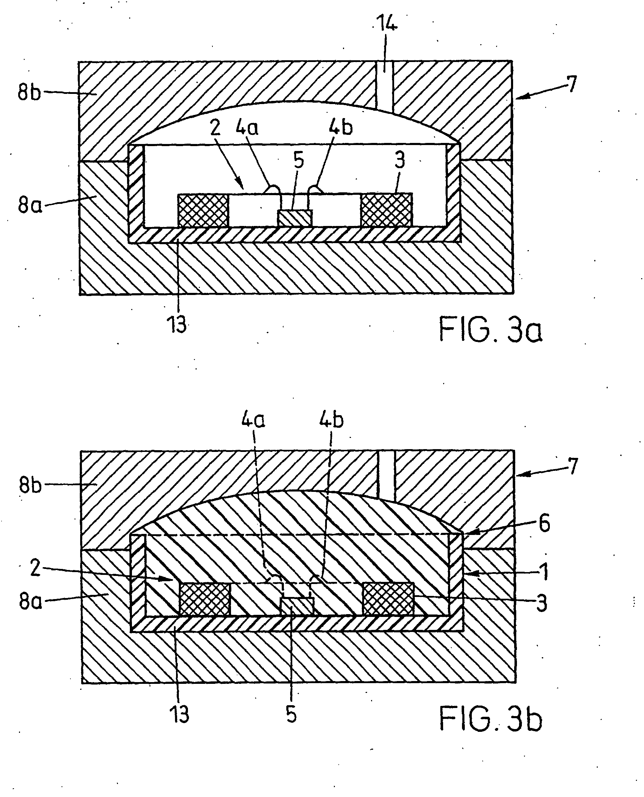

Bei einer dritten Ausführungsform des erfindungsgemässen Verfahrens wird (Fig. 3a,b) die Kavität 11 der Form 7 teilweise ausgekleidet, indem in die untere Formhälfte 8a eine feste becherartige Kunststoffhülse 13 eingelegt wird, auf deren Boden dann der Schaltkreis 2 befestigt wird. Nach Aufsetzen der oberen Formhälfte 8b (Fig. 3a) wird durch eine Einfüllöffnung 14 in derselben wiederum Schmelzkleber eingespritzt und die Kunststoffhülse 13 vollständig aufgefüllt. Nach dem Aushärten des Schmelzklebers wird der Transponder der Form 7 entnommen. Die Kunststoffhülse 13 und der Schmelzkleber bilden wiederum eine vollständige Kapselung 6.

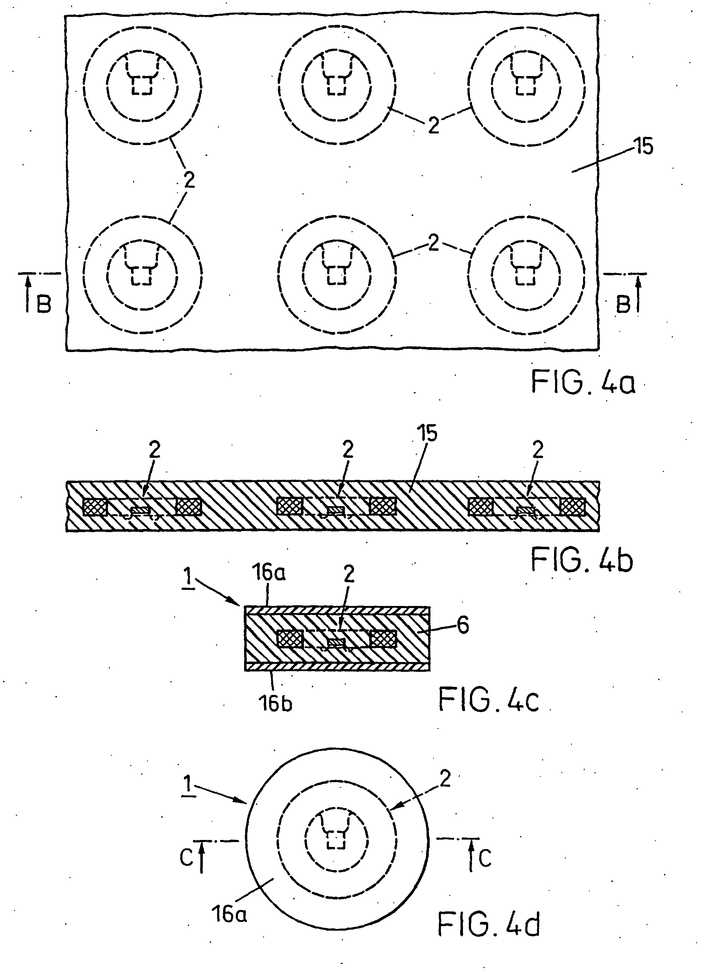

Gemäss einer vierten Ausführungsform des erfindungsgemässen Verfahrens zur Herstellung eines erfindungsgemässen Transponders werden mehrere Schaltkreise gleichzeitig umhüllt, so dass sie vorläufig durch die Umhüllung zusammengehalten werden. Die Vorgehensweise ist dabei prinzipiell die gleiche wie bei der ersten oder bei der zweiten Ausführungsform, doch ist die Form wesentlich grösser und ihre Kavität flach quaderförmig, so dass sich eine Vielzahl von Schaltkreisen in einem regelmässigen Raster in derselben anordnen lässt. Das Ergebnis des Spritzgussschrittes ist (Fig. 4a,b) eine zweidimensionale Anordnung von in Schmelzkleber eingebetteten Schaltkreisen 2, welche eine Platte 15 bildet. Die Schaltkreise 2 sind vom Schmelzkleber vollständig umhüllt und voneinander beabstandet.

Die Platte 15 kann dann ein- oder beidseitig mit einer Folie aus Kunststoff, vorzugsweise PVC heiss- oder kaltlaminiert werden. Anschliessend wird sie mittels eines Stanzwerkzeugs in einzelne, jeweils einen von einer Kapselung 6 vollständig umhüllten Schaltkreis 2 umfassende Transponder 1 zerlegt. Der Transponder 1 (Fig. 4c,d) ist im wesentlichen gleich aufgebaut wie die gemäss der ersten oder zweiten Ausführungsform des erfindungsgemässen Verfahrens hergestellten, doch weist er, wenn die Platte 15 beidseitig laminiert wurde, Deckschichten 16a,b auf, die vorzugsweise aus PVC bestehen, aber auch aus ABS, Polycarbonat, Polyester oder einem anderen geeigneten Material bestehen können. Die Platte 15-kann so präpariert werden, dass aus ihr unmittelbar eine Kredit- oder andere Karte oder eine Münze o. dgl. ausgestanzt werden kann, welche dann den Transponder 1 enthält.

Es ist auch möglich, mehrere Schaltkreise derart gemeinsam zu umhüllen, dass sie eine durch die Umhüllung zusammenhängende Zeile oder andere Anordnung von Transpondern bilden, die durch Verbindungsabschnitte, welche in einem späteren Arbeitsgang z. B. mechanisch durchtrennt werden, zusammengehalten wird.

Da die Schaltkreise durch die lückenlose Kapselung gegen hohe Drücke und Temperaturen geschützt sind, können erfindungsgemässe Transponder problemlos in Spritzgussteile integriert werden, indem sie vor dem Einspritzen der Spritzgussmasse beim konventionellen Spritzgussverfahren in der Kavität der Spritzgussform angeordnet werden. Es sei jedoch darauf hingewiesen, dass gerade in diesem Fall eine lückenlose Kapselung nicht unbedingt erforderlich ist. Oft genügt es auch, wenn die Bauteile des Schaltkreises jeweils durch einen ganz oder teilweise aus Schmelzkleber bestehenden Träger so verbunden sind, dass ihre gegenseitige Lage festgelegt ist. Dazu genügt es beispielsweise, dass die Bauteile jeweils teilweise oder überwiegend von einer zusammenhängenden Schmelzklebermasse umgeben sind, wie dies z. B. bei der ersten Ausführungsform des erfindungsgemässen Verfahrens nach dem ersten Spritzgussschritt der Fall ist (s. Fig. 1c,d).

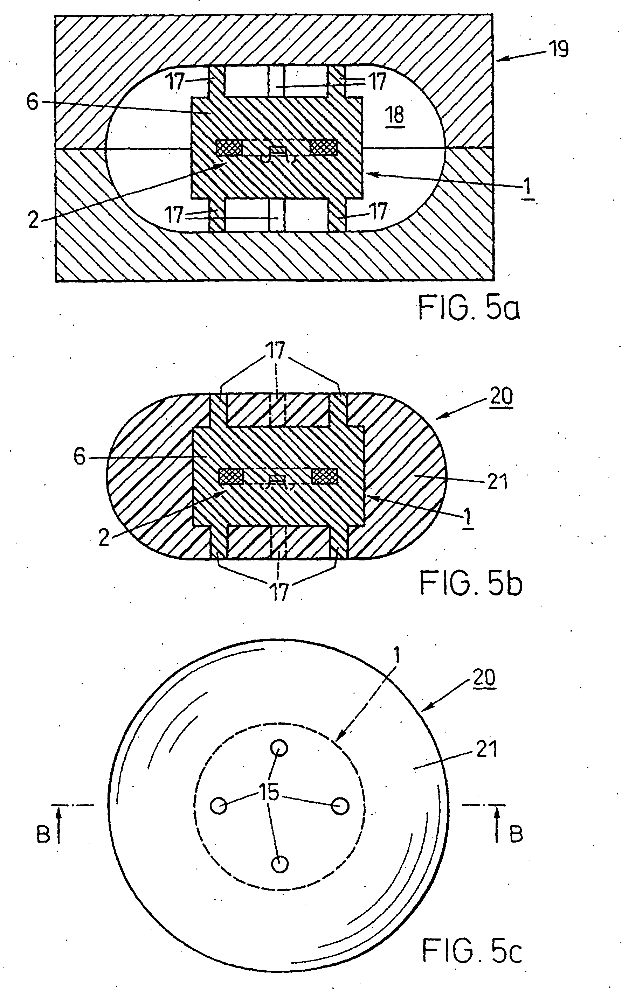

Transponder, die in Spritzgussteile integriert werden sollen, können zu diesem Zweck speziell ausgebildet und mit Abstützorganen versehen sein. Diese können (Fig. 5a-c) als beidseits von der Kapselung 6 abstehende Füsse 17 des Transponders 1 ausgebildet sein; welche durch entsprechende Ausbildung der bei der Herstellung desselben verwendeten Form oder z. B. durch Rückzug von Stiften, wie sie bei der zweiten Ausführungsform des erfindungsgemässen Verfahrens eingesetzt werden, hinter die Wand der Kavität beim Nachspritzen hergestellt werden. Jedenfalls stützen sie bei der erfindungsgemässen Herstellung eines erfindungsgemässen Spritzgussteils den Transponder 1 (Fig. 5a) in einer Kavität 18 einer aus gehärtetem Stahl bestehenden Spritzgussform 19. derart ab, dass er zuverlässig fixiert ist und beim Einspritzen der Spritzgussmasse nicht verschoben werden kann, obwohl dabei die Temperaturen um ca. 50°C höher liegen als bei der Herstellung der Kapselung 6 des Transponders 1 und die Drücke bei einigen hundert bar.

Es ist auch möglich, als Abstützorgan einen den Transponder z. B. ringförmig umgebenden Rahmen aus Kunststoff oder Metall vorzusehen, der mit der Kapselung vergossen ist und dessen äusserer Bereich dann zur Fixierung des Transponders zwischen den Hälften der Spritzgussform geklemmt wird.

Im fertigen erfindungsgemässen Spritzgussteil, im Beispiel einer Münze 20 oder einem Jeton, ist der Transponder 1 von einer im Spritzguss aufgebrachten Schale 21 fast vollständig umgeben. Da sie aus Spritzgussmaterial besteht, das viskoser ist und höheren Schmelzpunkt aufweist als der Schmelzkleber, der die Kapselung 6 des Transponders 1 bildet, ist die Schale 21 widerstandsfähiger und härter als diese und die Münze 20 entsprechend robust und beständig.

Der Transponder 1 kann in analoger-Weise auch in komplexere Spritzgussteile integriert werden, z. B. in Gefässe oder Behälter, Gehäuse, Paletten, Fahrzeugteile und Gebrauchsartikel aller Art.

### Bezugszeichenliste

- 1: Transponder
- 2: Schaltkreis
- 3: Spule
- 4a,b: Anschlüsse
- 5: integrierte Schaltung
- 6: Kapselung
- 7, 7': Form
- 8a, 8a': untere Formhälfte
- 8b, 8b': obere Formhälfte
- 9: Vertiefung
- 10: Auflagefläche
- 11, 11': Kavität
- 12a,b,c,d: Stifte
- 13: Kunststoffhülse
- 14: Einfüllöffnung
- 15: Platte
- 16a,b: Deckschicht
- 17: Füsse
- 18: Kavität
- 19: Spritzgussform
- 20: Münze
- 21: Schale

## Patentansprüche

1. Transponder (1) mit einem elektrischen Schaltkreis (2), welcher mindestens ein zur Wechselwirkung mit einem elektromagnetischen Feld geeignetes Bauteil und mindestens ein mit demselben elektrisch leitend verbundenes weiteres Bauteil enthält sowie mit einem Träger, welcher mindestens zum Teil aus einer Kunststoffmasse besteht, welche mit allen Bauteilen des elektrischen Schaltkreises derart in Verbindung steht, dass sie dieselben in einer bestimmten gegenseitigen Lage festhält, **dadurch gekennzeichnet, dass** die Kunststoffmasse ein Schmelzkleber ist.

2. Transponder nach Anspruch 1, **dadurch gekennzeichnet, dass** der Schmelzkleber im wesentlichen aus Polyamid besteht.

3. Transponder nach Anspruch 1 oder 2, **dadurch gekennzeichnet, dass** die Schmelztemperatur des Schmelzklebers höchstens 250°C, vorzugsweise höchstens 220°C beträgt.

4. Transponder nach einem der Ansprüche 1 bis 3, **dadurch gekennzeichnet, dass** der Träger ausschliesslich aus dem Schmelzkleber besteht.

5. Transponder nach einem der Ansprüche 1 bis 3, **dadurch gekennzeichnet, dass** der Träger ein Kunststoffteil umfasst, welches den Schaltkreis (2) trägt.

6. Transponder nach Anspruch 5, **dadurch gekennzeichnet, dass** das Kunststoffteil als Kunststoffhülse (13) ausgebildet ist, welche mit dem Schmelzkleber mindestens teilweise aufgefüllt ist.

7. Transponder nach einem der Ansprüche 1 bis 6, **dadurch gekennzeichnet, dass** der Träger eine Kapselung (6) bildet, welche den Schaltkreis (2) vollständig umhüllt.

8. Transponder nach einem der Ansprüche 1 bis 7, **dadurch gekennzeichnet, dass** mindestens ein Teil der Oberfläche des Trägers von einer Deckschicht (16a,b) aus auflaminierter Folie bedeckt ist.

9. Transponder nach Anspruch 8, **dadurch gekennzeichnet, dass** die Folie aus Kunststoff, insbesondere aus PVC besteht.

10. Transponder nach einem der Ansprüche 1 bis 9, **dadurch gekennzeichnet, dass** der Schaltkreis (2) als zur Wechselwirkung mit einem elektromagnetischen Feld geeignetes Bauteil eine Spule (3) umfasst.

11. Transponder nach Anspruch 10, **dadurch gekennzeichnet, dass** der Schaltkreis (2) als weiteres Bauteil eine mit der Spule (3) elektrisch leitend verbundene integrierte Schaltung (5) umfasst.

12. Verfahren zur Herstellung eines Transponders (1) nach einem der Ansprüche 1 bis 11, **dadurch gekennzeichnet, dass** mindestens ein Schaltkreis (2) in eine Kavität (11) einer Form (7) eingelegt wird und dann in die Kavität (11) flüssiger Schmelzkleber eingebracht und der mindestens eine Schaltkreis (2) teilweise von dem Schmelzkleber umhüllt wird.

13. Verfahren nach Anspruch 12, **dadurch gekennzeichnet, dass** der mindestens eine Schaltkreis (2) mit einer Auflagefläche (10) an einer Stützfläche in der Kavität (11) anliegt und nach Aushärten des Schmelzklebers die Auflagefläche (10) freigelegt und zur vollständigen Umhüllung des mindestens einen Schaltkreises (2) mit Schmelzkleber bedeckt wird.

14. Verfahren nach Anspruch 13, **dadurch gekennzeichnet, dass** der teilweise umhüllte mindestens eine Schaltkreis (2) in eine grössere Kavität (11') derart eingelegt wird, dass seine Auflagefläche (10) freiliegt und die grössere Kavität (11') mit Schmelzkleber gefüllt wird.

15. Verfahren nach Anspruch 14, **dadurch gekennzeichnet, dass** die Stützfläche durch mehrere Stifte (12a,b,c,d) gebildet wird, die nach der teilweisen Umhüllung des mindestens einen Schaltkreises (2) von der Auflagefläche (10) zurückgezogen werden, worauf die Kavität (11) wiederum mit Schmelzkleber aufgefüllt wird.

16. Verfahren nach Anspruch 12, **dadurch gekennzeichnet, dass** die Kavität (11) vor dem Einlegen des mindestens einen Schaltkreises (2) zum Teil mit einem Kunststoffteil ausgekleidet wird, auf welches derselbe aufgelegt wird und mit welchem sich der dann eingebrachte Schmelzkleber verbindet.

17. Verfahren nach Anspruch 16, **dadurch gekennzeichnet, dass** das Kunststoffteil als becherartige Kunststoffhülse (13) ausgebildet ist und mit Schmelzkleber aufgefüllt wird.

18. Verfahren nach einem der Ansprüche 11 bis 17, **dadurch gekennzeichnet, dass** mehrere Schaltkreise (2) derart gemeinsam umhüllt werden, dass sie durch die Umhüllung miteinander zusammenhängen.

19. Verfahren nach Anspruch 18, **dadurch gekennzeichnet, dass** die gemeinsame Umhüllung eine Platte (15) bildet, in welcher die Schaltkreise (2) gemäss einem bestimmten Raster angeordnet im Schmelzkleber eingebettet sind und anschliessend jeweils mindestens einen Schaltkreis (2) umfassende Transponder (1) aus der Platte (15) herausgestanzt werden.

20. Verfahren nach Anspruch 19, **dadurch gekennzeichnet, dass** die Platte (15) vor dem Herausstanzen der Transponder (1) einseitig oder beidseitig durch Laminieren mit einer Folie mit einer Deckschicht (14a,b) versehen wird.

21. Verfahren nach einem der Ansprüche 12 bis 20, **dadurch gekennzeichnet, dass** der flüssige Schmelzkleber mit einer Temperatur von höchstens 260°C, vorzugsweise höchstens 230°C und unter einem Druck von höchstens 40 bar, vorzugsweise höchstens 35 bar in die Kavität (11, 11') eingebracht wird.

22. Spritzgussteil mit einem in dasselbe integrierten Transponder (1) nach einem der Ansprüche 1 bis 11.

23. Verfahren zur Herstellung eines Spritzgussteils nach Anspruch 22, **dadurch gekennzeichnet, dass** der Transponder (1) in die Kavität (18) einer Spritzgussform (19) eingelegt wird, derart, dass er durch Abstützorgane in derselben fixiert ist und anschliessend Spritzgussmasse in die Kavität (18) eingespritzt wird.

## Claims

1. Transponder (1) having an electrical circuit (2) which comprises at least one component suitable for interacting with an electromagnetic field and at least one further component connected thereto in an electrically conductive manner, and having a support which at least partly comprises a plastics material which is connected to all components of the electrical circuit in such a way that it holds said component in a specific mutual position, **characterized in that** the plastics material is a hot-melt adhesive.

2. Transponder according to Claim 1, **characterized in that** the hot-melt adhesive essentially comprises polyamide.

3. Transponder according to Claim 1 or 2, **characterized in that** the melting point of the hot-melt adhesive is not more than 250°C, preferably not more than 220°C.

4. Transponder according to any of Claims 1 to 3,
**characterized in that** the support consists exclusively of the hot-melt adhesive.

5. Transponder according to any of Claims 1 to 3,
**characterized in that** the support comprises a plastics part which carries the circuit (2).

6. Transponder according to Claim 5, **characterized in that** the plastics part is in the form of a plastics sleeve (13) which is at least partly filled with the hot-melt adhesive.

7. Transponder according to any of Claims 1 to 6,
**characterized in that** the support forms a capsule (6) which completely envelops the circuit (2).

8. Transponder according to any of Claims 1 to 7,
**characterized in that** at least a part of the surface of the support is covered by a cover layer (16a, b) comprising a film applied by lamination.

9. Transponder according to Claim 8, **characterized in that** the film consists of plastic, in particular of PVC.

10. Transponder according to any of Claims 1 to 9,
**characterized in that** the circuit (2) comprises a coil (3) as the component suitable for interacting with an electromagnetic field.

11. Transponder according to Claim 10, **characterized in that** the circuit (2) comprises, as the further component, an integrated circuit (5) connected to the coil (3) in an electrically conductive manner.

12. Method for the production of a transponder (1) according to any of Claims 1 to 11, **characterized in that** at least one circuit (2) is placed in a cavity (11) of a mould (7) and liquid hot-melt adhesive is then introduced into the cavity (11) and the at least one circuit (2) is partly enveloped by the hot-melt adhesive.

13. Method according to Claim 12, **characterized in that** a support surface (10) of the at least one circuit (2) rests against a support surface in the cavity (11) and, after curing of the hot-melt adhesive, the support surface (10) is exposed and is covered with hot-melt adhesive for completely enveloping the at least one circuit (2).

14. Method according to Claim 13, **characterized in that** the partly enveloped at least one circuit (2) is placed in a larger cavity (11') in such a way that its support surface (10) is exposed, and the larger cavity (11') is filled with hot-melt adhesive.

15. Method according to Claim 14, **characterized in that** the support surface is formed by several pins (12a, b, c, d), which are drawn back from the support surface (10) after the partial enveloping of the at least one circuit (2), after which the cavity (11) is in turn filled with hot-melt adhesive.

16. Method according to Claim 12, **characterized in that,** before the introduction of the at least one circuit (2), the cavity (11) is partly lined with a plastics part on which said circuit is placed and to which the hot-melt adhesive then introduced bonds.

17. Method according to Claim 16, **characterized in that** the plastics part is in the form of a beaker-like plastics sleeve (13) and is filled with hot-melt adhesive.

18. Method according to any of Claims 11 to 17,
**characterized in that** several circuits (2) are enveloped together in such a way that they are cohesive with one another as a result of the enveloping.

19. Method according to Claim 18, **characterized in that** the common envelope forms a plate (15) in which the circuits (2), arranged according to a specific grid, are embedded in the hot-melt adhesive and transponders (1) comprising in each case at least one circuit (2) are punched out of the plate (15).

20. Method according to Claim 19, **characterized in that,** before the transponders (1) are punched out, the plate (15) is provided with a cover layer (14a, b) on one side or both sides by lamination with a film.

21. Method according to any of Claims 12 to 20,
**characterized in that** the liquid hot-melt adhesive is introduced at a temperature of not more than 260°C, preferably not more than 230°C, and under a pressure of not more than 40 bar, preferably not more than 35 bar, into the cavity (11, 11').

22. Injection-moulded part having a transponder (1) according to any of Claims 1 to 11 which is integrated therein.

23. Method for the production of an injection-moulded part according to Claim 22, **characterized in that** the transponder (1) is placed in the cavity of an injection mould (19) in such a way that it is fixed therein by support elements, and injection moulding material is then injected into the cavity (18).

## Revendications

1. Transpondeur (1) comportant un circuit de commutation électrique (2), contenant au moins un composant, approprié pour interaction avec un champ électromagnétique, et au moins un autre composant, relié à celui-ci de façon conductrice de l'électricité, ainsi qu'avec un support, constitué au moins en partie d'une masse de matière synthétique, qui est en liaison avec tous les composants du circuit de commutation électrique, de manière qu'il fixe ceux-ci en une position mutuelle déterminée, **caractérisé en ce que** la masse de matière synthétique est une colle à fusion.

2. Transpondeur selon la revendication 1, **caractérisé en ce que** la colle à fusion est essentiellement constituée de polyamide.

3. Transpondeur selon la revendication 1 ou 2, **caractérisé en ce que** la température de fusion de la colle à fusion est au plus de 250°C, de préférence au plus de 220°C.

4. Transpondeur selon l'une des revendications 1 à 3, **caractérisé en ce que** le support est exclusivement constitué de la colle à fusion.

5. Transpondeur selon l'une des revendications 1 à 3, **caractérisé en ce que** le support comprend une pièce en matière synthétique, portant le circuit de commutation (2).

6. Transpondeur selon la revendication 5, **caractérisé en ce que** la pièce en matière synthétique est réalisée sous la forme de douille en matière synthétique (13), remplie au moins partiellement de la colle à fusion.

7. Transpondeur selon l'une des revendications 1 à 6, **caractérisé en ce que** le support forme un encapsulage (6), enveloppant complètement le circuit dè commutation (2).

8. Transpondeur selon l'une des revendications 1 à 7, **caractérisé en ce qu'**au moins une partie de la surface du support est couverte par une couche de couverture (16a, b) constituée d'une feuille appliquée par laminage.

9. Transpondeur selon la revendication 8, **caractérisé en ce que** la feuille est constituée en matière synthétique en particulier de PVC.

10. Transpondeur selon l'une des revendications 1 à 9, **caractérisé en ce que** le circuit de commutation (2) comprend une bobine (3) pour faire office de composant convenant pour l'interaction avec un champ électromagnétique.

11. Transpondeur selon la revendication 10, **caractérisé en ce que** le circuit de commutation (2) comprend, à titre d'autre exposant, un circuit intégré (5) relié de façon conductrice de l'électricité à la bobine (3).

12. Procédé de fabrication d'un transpondeur (1) selon l'une des revendications 1 à 11, **caractérisé en ce qu'**au moins un circuit de commutation (2) est inséré dans une cavité (11) d'un moule (7) et, ensuite, de la colle à fusion liquide est introduite dans la cavité et ledit au moins un circuit de commutation (2) est partiellement enveloppé par la colle à fusion.

13. Procédé selon la revendication 12, **caractérisé en ce que** le au moins un circuit de commutation (2) s'appuie, par une surface de pose (10), sur une face d'appui ménagée dans la cavité (11) et, après durcissement de la colle à fusion, la surface de pose (10) est dégagée et couverte de colle à fusion, pour envelopper complètement le au moins un circuit de commutation (2).

14. Procédé selon la revendication 13, **caractérisé en ce que** le au moins un circuit de commutation (2) enveloppé partiellement est inséré dans une plus grande cavité (11'), defaçon à ce que sa face de pose (10) est dénudée et la plus grande cavité (11') est remplie de colle à fusion.

15. Procédé selon la revendication 14, **caractérisé en ce que** la face d'appui est formée par plusieurs tiges (12a, b, c, d), qui sont rétractées de la face de pose (10) après l'enveloppement partiel du au moins un circuit de commutation (2), suite à quoi la cavité (11) est de nouveau remplie de colle à fusion.

16. Procédé selon la revendication 12, **caractérisé en ce que,** avant insertion du au moins un circuit de commutation (2), la cavité (11) est revêtue en partie d'une pièce en matière synthétique sur laquelle celui-ci est posé et avec laquelle se lie la colle à fusion introduite ensuite.

17. Procédé selon la revendication 16, **caractérisé en ce que** la pièce en matière synthétique est réalisée sous la forme de douille en matière synthétique (13), du genre d'un godet et remplie de colle à fusion.

18. Procédé selon l'une des revendications 11 à 17, **caractérisé en ce que** plusieurs circuits de commutation (2) sont enveloppés conjointement, de manière à être en cohésion mutuelle au moyen de l'enveloppement.

19. Procédé selon la revendication 18, **caractérisé en ce que** l'enveloppement commun forme une plaque (15), dans laquelle les circuits de commutation (2) sont disposé selon une matrice déterminée, en étant noyé dans la colle à fusion, et ensuite des transpondeurs (1), comprenant chacun au moins un circuit de commutation (2), étant séparés de la plaque (15) par un processus d'estampage.

20. Procédé selon la revendication 19, **caractérisé en ce que,** avant le découpage d'estampage des transpondeurs (1), la plaque (15) est munie, sur une face ou sur les deux faces, par laminage avec une feuille, d'une couche de couverture (14a, b).

21. Procédé selon l'une des revendications 12 à 20, **caractérisé en ce que** la colle à fusion liquide est introduite dans la cavité (11, 11') à une température maximale de 260°C, de préférence maximale de 230°C et sous une pression maximale de 40 bar, de préférence une pression maximale de 35 bar.

22. Pièce moulée par injection, comportant un transpondeur (2) intégré dans celle-ci, selon l'une des revendications 1 à 11.

23. Procédé de fabrication d'une pièce moulée par injection selon la revendication 22, **caractérisé en ce que** le transpondeur (1) est inséré dans la cavité (18) d'un moule de coulée par injection (19), de manière qu'il soit fixé dans celui-ci à l'aide d'organes de soutien et, ensuite, la masse de moulage par injection étant injectée dans la cavité (18).
